# EUROPÄISCHE PATENTANMELDUNG

(11) **EP 2 065 101 A1**
(43) Veröffentlichungstag der Anmeldung: **03.06.2009**
(21) Anmeldenummer: 07023082.6
(22) Anmeldetag: 28.11.2007
(51) Int. Cl.: B05B 12/14, B05B 15/02

(54) **Lackiermaschine**

(71) Anmelder: SIEMENS AKTIENGESELLSCHAFT, 80333 München (DE)
(72) Erfinder: Hoffmann, Andreas, 91052 Erlangen (DE)

(57) **Zusammenfassung**

Eine Lackiermaschine (1) weist zumindest einen Spritzkopf (2) zum Lackieren eines oder mehrerer Objekte (3) und eine Pumpe (4) zur Förderung zumindest von Lack aus einem Lackbehälter (5) über eine Zulaufleitung (6) zu dem Spritzkopf (2) und zurück über eine Rücklaufleitung (7) zu dem Lackbehälter (5), wobei die Zulaufleitung (6) und die Rücklaufleitung (7) zur Reinigung der Lackiermaschine an einen Lösungsmittelbehälter (9) mit einem Lösungsmittel anschließbar sind. Erfindungsgemäß sind die Zulaufleitung (6) und die Rücklaufleitung (7) an einem Entsorgungsbehälter (15) zur Entsorgung von Lack- und Lösungsmittelresten anschließbar. Die Zulaufleitung (6) und die Rücklaufleitung (7) sind an ihrem jeweiligen behälterseitigen Ende an einem ersten und zweiten ansteuerbaren Mehrwegeventil (10, 20) zum Schalten der Zulaufleitung (6) und der Rücklaufleitung (6, 7) an den Lack-, Lösungsmittel- oder Entsorgungsbehälter (5, 9, 15) angeschlossen. Die Lackiermaschine (1) weist eine Steuereinrichtung (16) zum Ansteuern der Mehrwegeventile (10, 20) derart auf, dass nacheinander ein Entsorgen des Lacks, ein Befüllen mit Lösungsmittel, ein Spülreinigen der Lackiermaschine (1), ein Entsorgen des Lösungsmittels, ein Wiederbefüllen mit Lack sowie ein Weiterfördern des Lacks automatisiert durchführbar ist.

## Beschreibung

Die Erfindung betrifft eine Lackiermaschine mit zumindest einem Spritzkopf zum Lackieren eines oder mehrerer Objekte und mit einer Pumpe zur Förderung zumindest von Lack aus einem Lackbehälter über eine Zulaufleitung zu dem Spritzkopf und zurück über eine Rücklaufleitung zu dem Lackbehälter. Die Zulaufleitung und die Rücklaufleitung sind zur Reinigung der Lackiermaschine an einen Lösungsmittelbehälter mit einem Lösungsmittel anschließbar.

Derartige Lackiermaschinen dienen zum Lackieren beispielsweise von Bauteilen, Gehäuseteilen, Kraftfahrzeugen oder Leiterplatten.

Aus dem US-Patent US 7,156,112 B2 sind ein Verfahren sowie ein System zum Reinigen einer Lackieranlage bekannt. Das Reinigungssystem kann eingangsseitig an eine Rücklaufleitung und ausgangsseitig an eine Zulaufleitung des Lackkreislaufs zum Spülen des Lackkreislaufs mittels eines Lösungsmittels angeschlossen werden. Es kann alternativ eingangsseitig an die Zulaufleitung und ausgangsseitig an die Rücklaufleitung angeschlossen werden.

Aus der deutschen Offenlegungsschrift DE 41 36 000 A1 ist ein Verfahren zum Reinigen der Strömungskanäle einer automatisch arbeitenden Spritzbeschichtungsvorrichtung bekannt, die verschiedene Beschichtungen nacheinander auftragen kann. Bei dem Verfahren werden eine Druckquelle für ein Lösungsmittel sowie ein Vorrat eines Druckgases vorgesehen. Es werden gleichzeitig über Steuerventile das Lösungsmittel und das Druckgas einem Mischventil zugeführt. Das Gemisch aus Lösungsmittel und Gas wird durch die Strömungskanäle der Spritzbeschichtungsvorrichtung geschickt.

Um eine Verfestigen bzw. Aushärten des Lacks zu verhindern, ist es bekannt, dass der Lack in einem Kreislauf mittels einer Pumpe umgewälzt wird. Der Lack wird dabei aus einem Lackbehälter angesaugt und zu einem oder mehreren Spritzköpfen gefördert. Zumindest ein Teil des nicht versprühten Lacks wird dann wieder zu dem Lackbehälter zurückgefördert.

Um eine geforderte Qualität des Lackierprozesses aufrechtzuerhalten, muss eine solche Lackiermaschine regelmäßig gereinigt werden, um verfestigte Lackreste sowie Abriebstoffe zu entsorgen. Eine Reinigung ist auch dann erforderlich, wenn ein anderer Lacktyp, wie z.B. ein Lack mit einer anderen Farbe, zum Lackieren verwendet werden soll. Hierzu kann z.B. ein Reinigungssystem der eingangs beschriebenen Lackiermaschine verwendet werden. Allerdings wird zur Reinigung einer derartigen Lackiermaschine eine nachteilig hohe Menge des Lösungsmittels benötigt. Dies ist im Hinblick auf die steigenden Anforderungen an den Umweltschutz bedenklich.

Ausgehend von dem eingangs genannten Stand der Technik ist es eine Aufgabe der Erfindung, eine verbesserte und umweltfreundlichere Lackiermaschine anzugeben.

Die Aufgabe der Erfindung wird mit einer Lackiermaschine mit den Merkmalen des Patentanspruchs 1 gelöst. Vorteilhafte Ausführungsformen der Lackiermaschine sind in den abhängigen Ansprüchen 2 bis 10 genannt.

Erfindungsgemäß sind die Zulaufleitung und die Rücklaufleitung an einem Entsorgungsbehälter zur Entsorgung von Lack- und Lösungsmittelresten anschließbar. Die Zulaufleitung und die Rücklaufleitung sind an ihrem jeweiligen behälterseitigen Ende an einem ersten und zweiten ansteuerbaren Mehrwegeventil zum Schalten der Zulaufleitung und der Rücklaufleitung an den Lack-, Lösungsmittel- oder Entsorgungsbehälter angeschlossen. Die Lackiermaschine weist eine Steuereinrichtung zum Ansteuern der Mehrwegeventile derart auf, dass nacheinander ein Entsorgen des Lacks, ein Befüllen mit Lösungsmittel, ein Spülreinigen der Lackiermaschine, ein Entsorgen des Lösungsmittels, ein Wiederbefüllen mit Lack sowie ein Weiterfördern des Lacks automatisiert durchführbar ist.

Der große Vorteil ist, dass im Vergleich zum Stand der Technik die Lösungsmittelmenge stark reduziert wird, indem zu Beginn der Reinigungsphase Lackreste sowie die ersten Mischprodukte aus Lack und Lösungsmittel aus der Lackiermaschine in den Entsorgungsbehälter gefördert werden.

Ein weiterer Vorteil ist, dass im Vergleich zum Stand der Technik keine Druckluftquelle zum Antreiben einer gesonderten Umwälzpumpe für das Lösungsmittel benötigt wird.

Nach einer Ausführungsform weist das erste Mehrwegeventil drei Ventileingänge auf, wobei je ein Ventileingang an dem Lackbehälter, an dem Lösungsmittelbehälter oder an ein gasförmiges Medium angeschlossen ist. Das gasförmige Medium ist insbesondere Umgebungsluft. Das zweite Mehrwegeventil weist drei Ventilausgänge auf, wobei je ein Ventilausgang an dem Lack-, Lösungsmittel- oder Entsorgungsbehälter angeschlossen ist. Wesentlich ist, dass drei mögliche Wege von den drei Ventileingängen zur gemeinsamen Zulaufleitung sowie drei mögliche Wege von der gemeinsamen Rücklaufleitung zu den Ventilausgängen einstellbar sind. Ein derartiges Mehrwegeventil kann eine Baueinheit sein. Es kann alternativ durch Hintereinanderschaltung und/oder durch Parallelschaltung von herkömmlichen Ventilen mit einem einzigen Eingang und Ausgang realisiert sein.

Nach einer weiteren Ausführungsform ist dem zumindest einen Spritzkopf ein Absperrventil vorgeschaltet, welches bei Betätigung ein Passieren des Lacks zum Spritzkopf erlaubt. Mit anderen Worten wird das Objekt nur dann lackiert, wenn das Absperrventil durch die Steuereinrichtung angesteuert wird. Vorzugsweise ist das Absperrventil möglichst nahe am Spritzkopf angebracht, um möglichst alle Rohr- oder Schlauchleitungen der Lackiermaschine reinigen zu können. Zur Reinigung des verbleibenden kurzen Rohr- oder Schlauchleitungsstücks von dem Absperrventil zum Spritzkopf kann das Absperrventil kurzzeitig angesteuert werden. Weiterhin ist vorzugsweise jedem Spritzkopf ein Absperrventil vorgeschaltet. Alternativ kann allen Spritzköpfen oder einem Teil davon jeweils nur ein Absperrventil vorgeschaltet sein.

Einer weiteren Ausführungsform zufolge weist das jeweilige ansteuerbare Mehrwegeventil zumindest einen weiteren Ventileingang bzw. Ventilausgang auf, welcher jeweils an einen weiteren Lackbehälter angeschlossen ist. Die Steuereinrichtung ist derart ausgebildet, dass ein Wiederbefüllen mit Lack sowie ein Weiterfördern des Lacks wahlweise aus einem der angeschlossenen Lackbehälter durchführbar sind. Dadurch können unterschiedliche Lacktypen, insbesondere unterschiedliche Lackfarben, zum Einsatz kommen.

Vorzugsweise ist in der Zulaufleitung und/oder in der Rücklaufleitung eine Filtereinheit vorhanden. Sie dient zur Filterung des zirkulierenden Lacks in der Lackiermaschine. Sich dort ansammelnde Filterstoffe, wie z.B. feste Lackreste oder Abriebstoffe, können über ein Ablassventil entleert werden. Ist das Ablassventil nach einer weiteren Ausführungsform ein mittels der Steuereinrichtung ansteuerbares Ablassventil, so können die Filterstoffe, wenn das Ablassventil an dem Entsorgungsbehälter angeschlossen ist, während des Entsorgens des Lacks und/oder des Lösungsmittels in den Entsorgungsbehälter entsorgt werden.

Nach einer bevorzugten Ausführungsform sind die Ventile druckluftbetätigbar. Den jeweiligen Ventilen ist ein Druckluftventil vorgeschaltet, welches jeweils durch die Steuereinrichtung elektrisch ansteuerbar ist und welches über eine Druckluftleitung mit dem jeweiligen Ventil verbunden ist. Die Druckluftansteuerung verhindert ein mögliches Verpuffen oder Explodieren des üblicherweise brennbaren Lösungsmittels.

Nach einer Ausführungsform ist in zumindest einem der angeschlossenen Behälter ein Füllstandsmelder vorhanden. Der jeweilige Füllstandsmelder ist signal- oder datentechnisch mit der Steuereinrichtung verbunden. Dadurch kann mittels der Steuereinrichtung eine Warnmeldung ausgegeben werden, wenn der Lack und insbesondere das Lösungsmittel zuneige gehen. Es kann eine weitere Warnmeldung ausgegeben werden, wenn der Entsorgungsbehälter einen oberen Füllstand erreicht, das heißt, wenn der Entsorgungsbehälter gefüllt ist. Gegebenenfalls kann dann mittels der Steuereinrichtung ein weiteres Entleeren der Lackiermaschine gestoppt werden.

Nach einer weiteren Ausführungsform ist in der Zulauf- oder Rücklaufleitung eine Viskositätsmesseinheit zur Erfassung der Viskosität der Spritzflüssigkeit vorhanden. Die Viskositätsmesseinheit ist signal- oder datentechnisch mit der Steuereinrichtung verbunden. Dadurch ist vorteilhaft eine laufende Überprüfung des zirkulierenden Lacks hinsichtlich der geforderten Viskosität des Lacks innerhalb eines zulässigen Bereichs möglich. Die Viskositätsmesseinheit kann z.B. ein sogenanntes Stabinger-Viskosimeter sein.

Schließlich ist nach einer vorteilhaften Ausführungsform ein optischer Sensor zur Erfassung der optischen Eigenschaften des Lacks und/oder des Lösungsmittels in der Zulauf- oder Rücklaufleitung vorhanden. Der optische Sensor ist signal- oder datentechnisch mit der Steuereinrichtung verbunden. Eine optische Eigenschaft kann z.B. die Lichtdurchlässigkeit oder die Farbe sein. Dadurch kann im Rahmen der Reinigung die Lichtdurchlässigkeit, das heißt die Reinheit oder Klarheit, des Lösungsmittels ermittelt werden. So kann, nachdem während der Reinigungsphase der Lack entsorgt worden ist, die zunehmende Klarheit des anschließend zugeführten und sich mit den Lackresten mischenden Lösungsmittels erfasst werden. Erreicht dann das Lösungsmittel einen vorgegebenen Klarheitswert, so kann die Entsorgung des Lösungsmittels in den Entsorgungsbehälter gestoppt und in die zirkulierende Reinigungsphase übergegangen werden.

Die Erfindung sowie vorteilhafte Ausführungen der Erfindung werden im Weiteren anhand der nachfolgenden Figuren näher beschrieben. Es zeigen
- FIG 1: beispielhaft den Aufbau einer erfindungsgemäßen Lackiermaschine und
- FIG 2: beispielhaft ein Ablaufschema eines Reinigungszyklus.

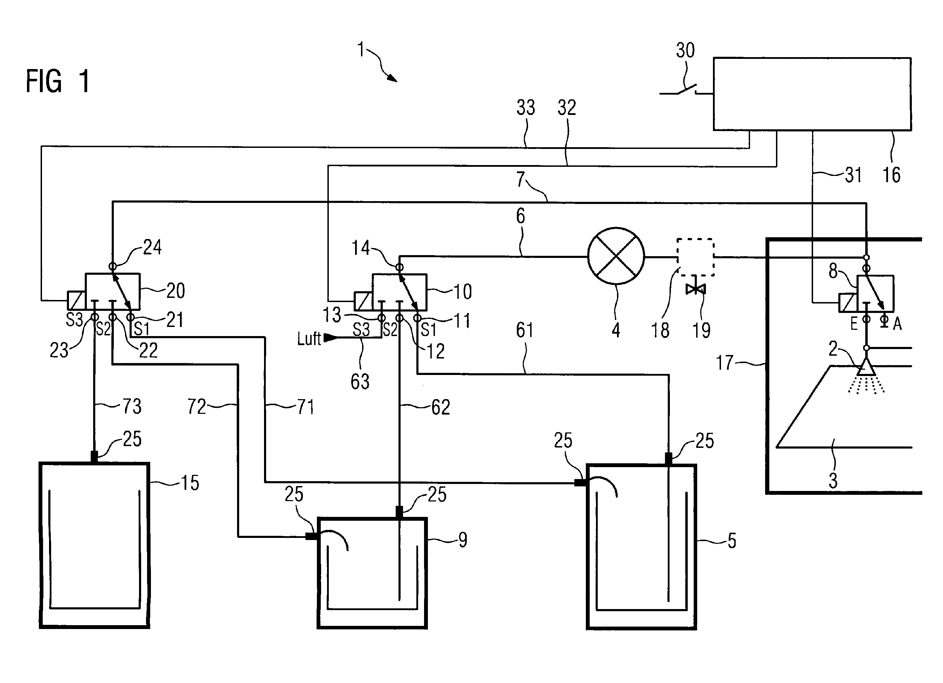

FIG 1 zeigt beispielhaft den Aufbau einer erfindungsgemäßen Lackiermaschine 1. Im rechten Teil der FIG 1 ist ausschnittsweise eine Spritzkabine 17 gezeigt. In der Spritzkabine 17 ist beispielhaft nur ein Spritzkopf 2 zum Lackieren eines Objektes 3 angeordnet. Er kann mittels einer nicht weiter gezeigten Verfahrmechanik zum Lackieren des Objekts 3 verfahren werden. Das Objekt 3 kann z.B. eine Flachbaugruppe sein, welche auf diese Weise mit einem Schutzlack versehen wird. Der Spritzkopf 2 ist eingangsseitig an eine Zulaufleitung 6 angeschlossen. In der Zulaufleitung 6 ist eine Pumpe 5 zur Förderung zumindest des Lacks vorgesehen. Die Pumpe 4 ist eingangsseitig an einen Lackbehälter 5 angeschlossen, aus welchem der Lack angesaugt wird. Ausgangsseitig ist der Spritzkopf 2 zur Rückführung des nicht versprühten Lacks an eine Rücklaufleitung 7 angeschlossen. Über diese wird der Lack zum Lackbehälter 5 zurückgefördert.

Im unteren Teil der FIG 1 ist der Lackbehälter 5, ein Lösungsmittelbehälter 15 sowie erfindungsgemäß ein Entsorgungsbehälter 15 zur Entsorgung von Lack- und Lösungsmittelresten gezeigt. Erfindungsgemäß sind die Zulaufleitung 6 und die Rücklaufleitung 7 an dem Entsorgungsbehälter 15 anschließbar bzw. angeschlossen. Die Zulaufleitung 6 und die Rücklaufleitung 7 sind an ihrem jeweiligen behälterseitigen Ende an einem ersten und zweiten ansteuerbaren Mehrwegeventil 10, 20 zum Schalten der Zulaufleitung 6 und der Rücklaufleitung 7 an den Lack-, Lösungsmittel- oder Entsorgungsbehälter 5, 9, 15 angeschlossen. Mit dem Bezugszeichen 16 ist eine Steuereinrichtung 16 bezeichnet, welche zum Ansteuern der Mehrwegeventile 10, 20 derart ausgebildet ist, dass nacheinander ein Entsorgen des Lacks, ein Befüllen mit Lösungsmittel, ein Spülreinigen der Lackiermaschine, ein Entsorgen des Lösungsmittels, ein Wiederbefüllen mit Lack sowie ein Weiterfördern des Lacks automatisiert durchführbar ist. Die gezeigte Steuereinrichtung 16 ist insbesondere eine speicherprogrammierbare Steuerung (SPS). Sie kann alternativ ein PC oder Industriecomputer sein. Die Steuereinrichtung 16 selbst kann an der Lackiermaschine 1 angeordnet sein. Sie kann alternativ über ein Datennetz, wie z.B. über ein Intranet, entfernt von der Lackiermaschine, angeordnet sein. Auf der Steuereinrichtung 16 ist ein Softwareprogramm zur Ansteuerung der Mehrwegeventile 10, 20 in der zuvor beschriebenen zeitlichen Reihenfolge ausführbar.

Das im mittleren Teil der FIG 1 dargestellte erste Mehrwegeventil 10 weist drei Ventileingänge 11-13 auf. Der erste Ventileingang 11 ist an dem Lackbehälter 5 angeschlossen. Der zweite Ventileingang 12 ist an dem Lösungsmittelbehälter 9 angeschlossen. Der dritte Ventileingang 13 ist unbeschaltet, das heißt offen. Mit den Bezugszeichen 61-63 sind Verbindungsleitungen in Form von Rohren oder Schläuchen bezeichnet. Mit dem Bezugszeichen 25 sind Leitungsanschlüsse an den Behältern 5, 9, 15 bezeichnet. Der im Mehrwegeventil 10 eingezeichnete Pfeil zeigt die Ruhestellung des Mehrwegeventils 10 an, wenn dieses über eine Ansteuerleitung 32 von der Steuereinrichtung 16 nicht angesteuert wird. In dieser Schaltstellung S1 fließt Lack aus dem Lackbehälter 5 durch das erste Mehrwegeventil 10 zum gemeinsamen Ventilanschluss 14 in die Zulaufleitung 6. In einer zweiten Schaltstellung S2 fließt vorzugsweise Lösungsmittel in die Zulaufleitung 6 und in einer dritten Schaltstellung S3 kann Außenluft in die Zulaufleitung 6 angesaugt werden.

Das im linken Teil der FIG 1 dargestellte zweite Mehrwegeventil 20 weist drei Ventilausgänge 21-23 auf. Der erste Ventilausgang 21 ist mit dem Lackbehälter 5 angeschlossen. Der zweite Ventilausgang 22 ist an dem Lösungsmittelbehälter 9 angeschlossen. Der dritte Ventilausgang 23 ist an dem Entsorgungsbehälter 15 angeschlossen. Mit den Bezugszeichen 71-73 sind wiederum Verbindungsleitungen in Form von Rohren oder Schläuchen bezeichnet. Der im zweiten Mehrwegeventil 20 eingezeichnete Pfeil zeigt die Ruhestellung an, wenn dieses über eine weitere Ansteuerleitung 33 von der Steuereinrichtung 16 nicht angesteuert wird. In dieser Schaltstellung S1 fließt typischerweise Lack aus der Rücklaufleitung 7 über einen gemeinsamen Ventilanschluss 24 in den Lackbehälter 5 zurück. In der zweiten Schaltstellung S2 fließt vorzugsweise Lösungsmittel zum Lösungsmittelbehälter 9 zurück. In der dritten Schaltstellung S3 fließen vorzugsweise Lack- und/oder Lösungsmittelreste in den Entsorgungsbehälter 15.

Im Beispiel der FIG 1 weist die Steuereinrichtung 16 ein Schaltmittel 30, insbesondere einen Taster, zum Starten der Reinigung der erfindungsgemäßen Lackiermaschine 1 auf. Weiterhin ist in der Zulaufleitung 6 eine optionale, gestrichelt gezeichnete Filtereinheit 18 vorhanden. Die in der Filtereinheit 18 gesammelten Filterstoffe können über ein Ablassventil 19 entleert werden. Zeichnerisch nicht dargestellt, kann das Ablassventil 19 an dem Entsorgungsbehälter 15 angeschlossen sein. Ist das Ablassventil 19 ein ansteuerbares Ablassventil 19, so können die Filterstoffe über die Steuereinrichtung 16 während des Entsorgens des Lacks und/oder des Lösungsmittels gleichfalls in den Entsorgungsbehälter 15 entsorgt werden.

Im Beispiel der FIG 1 ist weiterhin dem Spritzkopf 2 ein Absperrventil 8 vorgeschaltet. Dies erlaubt je nach Ventilstellung E, A ein Passieren des Lacks zum Spritzkopf 2.

Darüber hinaus kann das jeweilige ansteuerbare Mehrwegeventil 10, 20 zumindest einen weiteren Ventileingang bzw. Ventilausgang aufweisen, welcher jeweils an einen weiteren Lackbehälter angeschlossen ist. In diesem Fall ist die Steuereinrichtung 16 derart ausgebildet, dass ein Wiederbefüllen mit Lack sowie ein Weiterfördern des Lacks wahlweise aus einem der angeschlossenen Lackbehälter durchführbar sind. Dadurch können durch entsprechende Programmierung oder Ansteuerung der Steuereinrichtung 16 verschiedene Lacktypen oder Lackfarben zum Lackieren der Objekte 3 ausgewählt werden. Aus Gründen der Übersichtlichkeit ist in der FIG 1 nur ein Lackbehälter 5 dargestellt.

Im Beispiel der FIG 1 werden die Ventile 8, 10, 19, 20 über elektrische Signale der Steuereinrichtung 16 angesteuert. Alternativ dazu können die Ventile 8, 10, 19, 20 druckluftbetätigbare Ventile sein, welchen jeweils ein elektrisch ansteuerbares Druckluftventil vorgeschaltet ist. Die Druckluftventile können mittels der Steuereinrichtung 16 elektrisch angesteuert werden, welche dann ihrerseits die Ventile 8, 10, 19, 20 über Druckluft ansteuern. Die Druckluftventile sind im Beispiel der FIG 1 gleichfalls aus Gründen der Übersichtlichkeit nicht dargestellt, ebenso wie eventuell in oder an den Behältern 5, 9, 15 angeordnete Füllstandsmelder oder in der Zulauf- oder Rücklaufleitung 6, 7 oder in einem Lackbehälter 5 vorhandene Viskositätsmesseinheiten zur Erfassung der Viskosität des Lacks. Es wurde gleichfalls auf die Darstellung von optischen Sensoren zur Erfassung der optischen Eigenschaften des Lacks und/oder des Lösungsmittels verzichtet. Entsprechende Sensorsignale können gegebenenfalls von der Steuereinrichtung 16 erfasst und prozesstechnisch berücksichtigt werden.

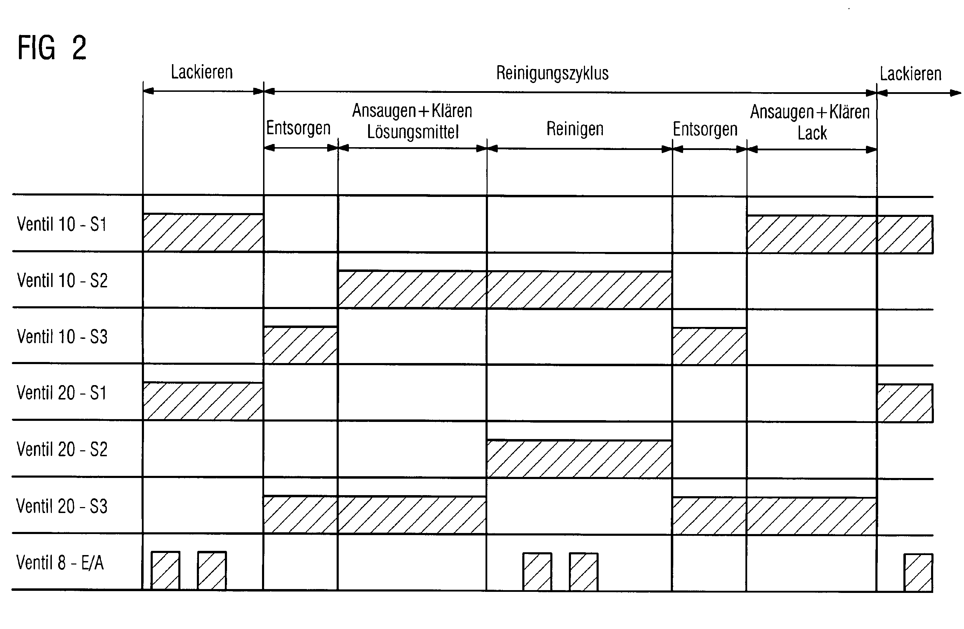

FIG 2 zeigt beispielhaft ein Ablaufschema eines Reinigungszyklus. Die Spalte im linken Teil der FIG 2 zeigt die Schaltstellung S1-S3 des ersten und zweiten Mehrwegeventils 10, 20 sowie die Ein- und Ausstellung E, A des Absperrventils 8 am Spritzkopf 2 der Lackiermaschine 1. Von links nach rechts sind die zeitlichen Schritte des Reinigungszyklus dargestellt, beginnend nach einem betriebsmäßigen Lackierschritt "Lackieren". Nach dem Ende des Reinigungszyklus startet wiederum ein betriebsmäßiger Lackierschritt "Lackieren". Aktive Schaltstellung S1-S3, E, A sind als schraffierte Blöcke dargestellt.

Im Schritt "Lackieren" sind die beiden Mehrwegeventile 10, 20 in der Schaltstellung S1. In diesem Fall wird Lack aus dem Lackbehälter 5 zum Spritzkopf 2 gefördert. Während der Einschaltzeiten des Absperrventils 8 wird der Lack versprüht und in den Ausschaltzeiten über das zweite Mehrwegeventil 20 in den Lackbehälter 5 zurückgeführt.

Im nachfolgenden Schritt "Entsorgen" befinden sich die beiden Mehrwegeventile 10, 20 in der Schaltstellung S3. Der in der Lackiermaschine 1 vorhandene Lack wird über das zweite Mehrwegeventil 20 mittels der Pumpe 4 in den Entsorgungsbehälter 15 entsorgt, während gleichzeitig Außenluft über das erste Mehrwegeventil 10 zum Nachfüllen des entleerten Lacks nachgezogen wird.

Im nächsten Schritt "Ansaugen + Klären Lösungsmittel" schaltet das erste Mehrwegeventil 10 von der Schaltstellung S3 in die Schaltstellung S2. In diesem Fall wird mittels der Pumpe 4 über das erste Mehrwegeventil 10 Lösungsmittel angesaugt, welches zuerst die Zulaufleitung 6 und dann die Rücklaufleitung 7 durchspült und dabei zunehmend "verschmutzt". Am Ende der Rücklaufleitung 7 wird das verschmutzte Lösungsmittel in den Entsorgungsbehälter 15 entsorgt. Dieser Schritt kann zeitgesteuert sein. Vorzugsweise signalisiert ein optischer Sensor der Steuereinrichtung 16, dass ein vorgegebener Reinheits- oder Klarheitsgrad des typischerweise transparenten Lösungsmittels erreicht ist.

Ist dies der Fall, schaltet das zweite Mehrwegeventil 20 in dem Schritt "Reinigen" gleichfalls in die Schaltstellung S2. Das nun in der Lackiermaschine 1 befindliche Lösungsmittel zirkuliert und löst mit der Zeit Lackreste, die sich im Laufe des Lackierbetriebes an den Rohren, Schläuchen und Armaturen festgesetzt haben. Im Schritt "Reinigen" kann das Absperrventil 8 kurzzeitig angesteuert werden, um Farbreste im Leitungsstück vom Absperrventil 8 zum Spritzkopf 2 zu reinigen.

Vorzugsweise nach Ablauf einer vorgegebenen Reinigungszeit schalten beide Mehrwegeventile 10, 20 im Schritt "Entsorgen" in die Schaltstellung S3. Das in der Lackiermaschine 1 vorhandene Lösungsmittel wird über das zweite Mehrwegeventil 20 mittels der Pumpe 4 in den Entsorgungsbehälter 15 entsorgt, während gleichzeitig Außenluft über das erste Mehrwegeventil 10 nachgezogen wird.

Im nächsten Schritt "Ansaugen + Klären Lack" schaltet das erste Mehrwegeventil 10 von der Schaltstellung S3 in die Schaltstellung S1. In diesem Fall wird mittels der Pumpe 4 über das erste Mehrwegeventil 10 neuer Lack angesaugt, welches zuerst durch die Zulaufleitung 6 und dann durch die Rücklaufleitung 7 hindurchfließt. Der zuerst hindurch geförderte Teil des neuen Lacks wird durch Lösungsmittelreste noch verdünnt und ist zum Versprühen, das heißt zum Lackieren, nicht geeignet. Dieser Teil wird am Ende der Rücklaufleitung 7 in den Entsorgungsbehälter 15 entsorgt. Dieser Schritt kann zeitgesteuert sein. Vorzugsweise signalisiert ein optischer Sensor der Steuereinrichtung 16, dass ein vorgegebener Farbsättigungswert als optische Eigenschaft erreicht ist.

Sind mehrere Lackbehälter vorhanden und weisen die Mehrwegeventil 10, 20 weitere Ein- und Ausgänge sowie weitere Schaltstellungen zum Ansaugen und Rückführen der weiteren Lacke auf, so ist ein entsprechender Farbsensor erforderlich. Durch Vergleich der optischen Kenndaten der verwendeten Lacke mit den entsprechenden erfassten Farbwerten und Farbsättigungswerten kann ein Signal erzeugt werden, welches das Erreichen der geforderten Lackqualität anzeigt. Der Vergleich kann z.B. mittels einer geeigneten Softwareroutine der Steuereinrichtung 16 ausgeführt werden.

Mit Umschalten der Mehrwegeventile 10, 20 in die Schaltstellung S0 ist das Ende des Reinigungszyklus erreicht.

## Patentansprüche

1. Lackiermaschine mit zumindest einem Spritzkopf (2) zum Lackieren eines oder mehrerer Objekte (3) und mit einer Pumpe (4) zur Förderung zumindest von Lack aus einem Lackbehälter (5) über eine Zulaufleitung (6) zu dem Spritzkopf (2) und zurück über eine Rücklaufleitung (7) zu dem Lackbehälter (5), wobei die Zulaufleitung (6) und die Rücklaufleitung (7) zur Reinigung der Lackiermaschine an einen Lösungsmittelbehälter (9) mit einem Lösungsmittel anschließbar sind,
**dadurch gekennzeichnet,**
**dass** die Zulaufleitung (6) und die Rücklaufleitung (7) an einem Entsorgungsbehälter (15) zur Entsorgung von Lack- und Lösungsmittelresten anschließbar sind, dass die Zulaufleitung (6) und die Rücklaufleitung (7) an ihrem jeweiligen behälterseitigen Ende an einem ersten und zweiten ansteuerbaren Mehrwegeventil (10, 20) zum Schalten der Zulaufleitung (6) und der Rücklaufleitung (7) an den Lack-, Lösungsmittel- oder Entsorgungsbehälter (5, 9, 15) angeschlossen sind und dass die Lackiermaschine eine Steuereinrichtung (16) zum Ansteuern der Mehrwegeventile (10, 20) derart aufweist, dass nacheinander ein Entsorgen des Lacks, ein Befüllen mit Lösungsmittel, ein Spülreinigen der Lackiermaschine, ein Entsorgen des Lösungsmittels, ein Wiederbefüllen mit Lack sowie ein Weiterfördern des Lacks automatisiert durchführbar ist.

2. Lackiermaschine nach Anspruch 1,
**dadurch gekennzeichnet, dass** das erste Mehrwegeventil (10) drei Ventileingänge (11-13) aufweist, wobei je ein Ventileingang (11-13) an dem Lackbehälter (5), an dem Lösungsmittelbehälter (9) oder an ein gasförmiges Medium angeschlossen ist, und dass das zweite Mehrwegeventil (20) drei Ventilausgänge (21-23) aufweist, wobei je ein Ventilausgang (21-23) an dem Lack-, Lösungsmittel- oder Entsorgungsbehälter (5, 9, 15) angeschlossen ist.

3. Lackiermaschine nach Anspruch 1 oder 2,
**dadurch gekennzeichnet, dass** dem zumindest einen Spritzkopf (2) ein Absperrventil (8) vorgeschaltet ist, welches je nach Ventilstellung (E, A) ein Passieren des Lacks zum Spritzkopf (2) erlaubt oder nicht.

4. Lackiermaschine nach einem der vorangegangenen Ansprüche,
**dadurch gekennzeichnet,**
**dass** das jeweilige ansteuerbare Mehrwegeventil (10, 20) zumindest einen weiteren Ventileingang bzw. Ventilausgang aufweist, welcher jeweils an einen weiteren Lackbehälter angeschlossen ist und dass die Steuereinrichtung (16) derart ausgebildet ist, dass ein Wiederbefüllen mit Lack sowie ein Weiterfördern des Lacks wahlweise aus einem der angeschlossenen Lackbehälter durchführbar ist.

5. Lackiermaschine nach einem der vorangegangenen Ansprüche,
**dadurch gekennzeichnet,**
**dass** in der Zulaufleitung (6) und/oder in der Rücklaufleitung (7) eine Filtereinheit (18) vorhanden ist und dass in der Filtereinheit (6) gesammelte Filterstoffe über ein Ablassventil (19) entleerbar sind.

6. Lackiermaschine nach Anspruch 5,
**dadurch gekennzeichnet, dass** ein ansteuerbares Ablassventil (19) vorhanden ist, welches an dem Entsorgungsbehälter (15) angeschlossen ist und welches mittels der Steuereinrichtung (16) während des Entsorgens des Lacks und/oder des Lösungsmittels zum Entsorgen der Filterstoffe ansteuerbar ist.

7. Lackiermaschine nach einem der vorangegangenen Ansprüche,
**dadurch gekennzeichnet,**
**dass** die Ventile (8, 10, 19, 20) druckluftbetätigbar sind und dass den jeweiligen Ventilen (8, 10, 19, 20) ein Druckluftventil vorgeschaltet ist, welches jeweils durch die Steuereinrichtung (16) elektrisch ansteuerbar ist und über eine Druckluftleitung mit dem jeweiligen Ventil (8, 10, 19, 20) verbunden ist.

8. Lackiermaschine nach einem der vorangegangenen Ansprüche,
**dadurch gekennzeichnet,**
**dass** in zumindest einem der angeschlossenen Behälter (5, 9, 15) ein Füllstandsmelder vorhanden ist und dass der jeweilige Füllstandsmelder signal- oder datentechnisch mit der Steuereinrichtung (16) verbunden ist.

9. Lackiermaschine nach einem der vorangegangenen Ansprüche,
**dadurch gekennzeichnet,**
**dass** in der Zulauf- oder Rücklaufleitung (6, 7) eine Viskositätsmesseinheit zur Erfassung der Viskosität der Spritzflüssigkeit vorhanden ist und dass die Viskositätsmesseinheit signal- oder datentechnisch mit der Steuereinrichtung (16) verbunden ist.

10. Lackiermaschine nach einem der vorangegangenen Ansprüche,
**dadurch gekennzeichnet,**
**dass** in der Zulauf- oder Rücklaufleitung (6, 7) ein optischer Sensor zur Erfassung der optischen Eigenschaften des Lacks und/oder des Lösungsmittels vorhanden ist und dass der optische Sensor signal- oder datentechnisch mit der Steuereinrichtung (16) verbunden ist.
